# FASCICULE DE BREVET EUROPEEN

(11) **EP 1 222 842 B1**
(45) Date de publication et mention de la délivrance du brevet: **02.04.2003**
(21) Numéro de dépôt: 00968058.8
(22) Date de dépôt: 17.10.2000
(51) Int. Cl.: H05G 2/00

(54) **GENERATION D'UN BROUILLARD DENSE DE GOUTTELETTES MICROMETRIQUES NOTAMMENT POUR LA LITHOGRAPHIE DANS L'UV EXTREME**
ERZEUGUNG EINES DICHTEN NEBELS VON MIKROMETRISCHEN TRÖPFCHEN INSBESONDERE FÜR DIE EUV- LITHOGRAPHIE
PRODUCTION OF A DENSE MIST OF MICROMETRIC DROPLETS IN PARTICULAR FOR EXTREME UV LITHOGRAPHY

(30) Priorité: 18.10.1999 FR 9912949
(43) Date de publication de la demande: 17.07.2002
(73) Titulaire: COMMISSARIAT A L'ENERGIE ATOMIQUE, 75752 Paris Cédex 15 (FR)
(72) Inventeur: SCHMIDT, Martin, F-92170 Vanves (FR); SUBLEMONTIER, Olivier, F-92260 Fontenay aux Roses (FR)
(74) Mandataire: Weber, Etienne Nicolas
(86) Numéro de dépôt international: FR0002890
(87) Numéro de publication internationale: WO01030122

(56) Documents cités:
- EP-A- 0 858 249
- WO-A-97/40650
- WO-A-99/51357
- US-A- 4 723 262
- US-A- 5 577 092
- PATENT ABSTRACTS OF JAPAN vol. 007, no. 158 (E-186), 12 juillet 1983 (1983-07-12) & JP 58 066296 A (SUWA SEIKOSHA KK), 20 avril 1983 (1983-04-20)

## Description

### DOMAINE TECHNIQUE

La présente invention concerne un procédé et un dispositif de génération d'un brouillard dense de gouttelettes micrométriques et submicrométriques.

Elle s'applique notamment à la génération d'un rayonnement extrême ultraviolet que l'on appelle également « rayonnement EUV ».

Il s'agit d'un rayonnement dont la longueur d'onde est comprise dans le domaine allant de 8 nanomètres à 25 nanomètres.

Le rayonnement EUV produit grâce à la présente invention a de nombreuses applications, notamment en science des matériaux, en microscopie et tout particulièrement en lithographie, pour fabriquer des circuits intégrés à très haut degré d'intégration.

On peut également citer, en tant qu'application, le dépôt d'agrégats en surface, pour lequel des agrégats gros et chauds conviennent mieux que les agrégats petits et froids générés par tous les dispositifs de l'art antérieur.

### ÉTAT DE LA TECHNIQUE ANTÉRIEURE

On connaît diverses techniques de production d'un rayonnement EUV, par exemple celle qui consiste à irradier par un faisceau laser une cible placée dans le vide (« vacuum »).

Lorsque l'éclairement par le faisceau laser est suffisamment intense, la cible est fortement ionisée. On crée ainsi un plasma dont un certain nombre de particules, excitées et/ou ionisées par le champ électromagnétique résultant du faisceau laser et par des collisions avec les autres particules du plasma, se désexcitent ou se recombinent en émettant de la lumière dans l'extrême ultraviolet. Une sorte de conversion de fréquence a ainsi lieu au coeur de la cible.

On connaît plusieurs types de cibles destinées à obtenir un rendement de conversion de fréquence élevé de manière à produire la lumière EUV la plus intense possible.

En particulier, dans le domaine de la lithographie des circuits intégrés, il faut trouver une cible qui soit susceptible d'être irradiée par un laser pour la production de lumière dans l'extrême ultraviolet et qui soit compatible avec une exploitation industrielle de la lithographie. Une telle cible doit satisfaire aux exigences suivantes :
- Les débris causés par interaction entre la cible et le faisceau laser doivent être réduits au minimum de façon à ne pas endommager les optiques très coûteuses de l'appareil de lithographie.
- La matière composant la cible doit pouvoir être fournie en continu ou en mode pulsé à haute cadence, par exemple de l'ordre de 1 kHz. Cette matière doit donc être constamment renouvelable.
- Le laser étant focalisé sur la cible, la quantité de matière irradiée doit être suffisamment importante pour permettre une émission intense dans l'extrême ultraviolet. Cela impose deux conditions sur la cible. Premièrement, les dimensions de cette cible ne doivent pas être trop faibles. Deuxièmement, la densité moyenne de la cible doit être suffisamment importante.
- La cible doit être placée sous vide, dans une zone où la pression est par exemple de l'ordre de 10⁻² Pa. Les moyens de pompage permettant d'obtenir une telle pression doivent être exempts de vibrations.
- Le transfert d'énergie entre le laser et la cible doit être efficace pour garantir un rendement de conversion élevée.
- Le dispositif de génération de la cible doit être fiable à long terme. L'interaction entre le laser et la cible doit en particulier avoir lieu à une distance suffisamment grande de ce dispositif de manière à éviter l'usure prématurée de ce dernier par l'impact des ions éjectés du plasma. Ceci mène à la génération de débris solides qui proviennent de l'érosion de la buse.

La génération d'un rayonnement EUV, par irradiation d'un jet dense d'agrégats de xénon sur lequel on focalise un faisceau émis par un laser nanoseconde, est connue par le document US-A-5577092 [1] qui, comme les autres documents cités dans la suite, est mentionné à la fin de la présente description.

On rappelle que ces agrégats de xénon sont des grains de taille submicrométrique qui sont obtenus par condensation du xénon lors d'une expansion adiabatique à travers une buse dans une enceinte à vide.

L'irradiation de ces agrégats par un faisceau laser dans le proche infrarouge ou le proche ultraviolet produit un plasma qui émet une lumière plus énergétique située dans l'extrême ultraviolet. Le couplage entre le laser et la cible, et donc l'efficacité de ce processus de conversion, sont particulièrement importants dans le cas de l'irradiation d'un jet d'agrégats de Xénon.

Une partie importante de la lumière laser est ainsi absorbée, ce qui favorise la création d'un plasma par échauffement des agrégats. Cette efficacité du processus de conversion est due aux dimensions très réduites des agrégats (inférieures à 0,1 µm), ce qui favorise une pénétration quasi-totale de la lumière laser dans chaque agrégat.

De plus, la densité locale des atomes dans chaque agrégat est très élevée, ce qui fait donc intervenir un grand nombre d'atomes. En outre, le grand nombre d'agrégats comportant un nombre moyen d'atomes suffisamment élevé et se trouvant dans la zone de focalisation du faisceau laser rend l'émission dans l'extrême ultraviolet considérable.

Un autre avantage d'une source de rayonnement EUV fondée sur l'irradiation d'un jet d'agrégats par un laser nanoseconde réside dans l'absence quasi-totale de débris matériels, c'est-à-dire de fragments rapides de matière, émis par le jet irradié, débris qui pourraient endommager les optiques de collection de rayonnement EUV.

Par contre des débris matériels importants peuvent résulter de l'érosion de la buse lorsque celle-ci est placée trop près de la zone illuminée. Ainsi, l'enseignement des documents [1] et [7] conduit à placer la zone illuminée à une faible distance de la buse (1 à 2 mm), ce qui entraîne la génération d'importants débris, due à l'érosion de la buse.

L'utilisation d'un jet, qui constitue une cible renouvelable, permet de travailler à haute cadence (de l'ordre de 1 kHz ou plus), ce qui est adapté aux appareils de lithographie pour la fabrication de circuits intégrés à très haut degré d'intégration.

L'utilisation de xénon comme gaz d'agrégation donne les meilleurs résultats en ce qui concerne l'émission d'extrême ultraviolet car le xénon est le gaz (a) qui assure l'un des meilleurs degrés de condensation et permet ainsi d'obtenir une taille moyenne assez élevée pour les agrégats et (b) qui dispose d'un grand nombres de raies d'émission dans la gamme spectrale considérée.

De plus, la zone d'interaction entre le faisceau laser et le jet d'agrégats est petite, ce qui permet de condenser un maximum de rayonnements EUV tout en minimisant les aberrations optiques.

La source de rayonnement EUV, qui est connue par le document [1], présente cependant un certain nombre d'inconvénients :
- Il est nécessaire de refroidir fortement la buse d'expansion, ce qui nécessite d'importants moyens cryogéniques.
- La fiabilité du dispositif de génération d'agrégats, lorsque la buse est refroidie, est réduite par la présence d'un fort gradient thermique entre l'extrémité refroidie de la buse et le mécanisme de mouvement de la vanne pulsée où a lieu un échauffement local.
- Un fonctionnement à haute cadence (de l'ordre de 1 kHz) nécessite des flux de gaz considérables, ce qui demande des moyens de pompage très importants, susceptibles d'induire des vibrations nuisibles à l'alignement des optiques d'un appareil de lithographie comprenant le dispositif de génération d'agrégats.
- Dans le cas du xénon, des moyens de récupération de gaz sont nécessaires afin de minimiser les coûts qui risqueraient de devenir prohibitifs à l'échelle industrielle.
- Le processus de génération de rayonnement EUV ne doit se produire que dans une petite zone, de diamètre inférieur à 1 mm. En conséquence, seule une quantité restreinte du gaz au sein du jet est réellement utilisée. Or, selon le document [1], figure 5, et le document [7] figure 5, la densité d'agrégats décroît fortement lorsqu'on s'éloigne de la buse. C'est pourquoi l'excitation par le faisceau laser doit avoir lieu à proximité immédiate de la buse, ce qui entraîne une érosion importante de cette buse (qui est généralement métallique) par l'impact d'ions issus du plasma. L'érosion de la buse réduit de façon significative sa durée de vie, et donc la fiabilité de la source de rayonnement EUV, et génère d'importantes quantités de débris susceptibles de détériorer les optiques et le masque de l'appareil de lithographie.

Le document [2] divulgue une source de rayonnement EUV qui utilise, en tant que cible, un jet de microcristaux de glace. Il s'agit d'une succession de microcristaux à très haute cadence de répétition où chaque microcristal a typiquement un diamètre de plusieurs dizaines de micromètres.

De tels microcristaux sont trop gros pour que la pénétration du faisceau laser d'excitation soit complète, contrairement à ce qui se produit avec les agrégats de xénon. Une réduction du diamètre de chaque microcristal permet d'améliorer la pénétration mais au détriment du rendement car on réduit le nombre d'émetteurs de photons EUV dans le plasma.

La technique décrite dans le document [2] ne satisfait donc pas aux critères d'obtention d'une source de rayonnement EUV suffisamment intense.

On connaît par le document WO97/40650 [3] une autre source de rayonnement EUV fondée sur l'irradiation d'un micro-jet continu d'azote liquide. Ce genre de cible présente également l'inconvénient de contenir une quantité de matière beaucoup trop faible pour avoir un nombre suffisant d'émetteurs EUV potentiels. Ceci est dû au diamètre relativement faible (environ 10 µm) du jet d'azote liquide.

De plus, les sources connues par les documents [2] et [3] sont peu stables du point du vue de l'intensité. Dans le cas du document [2], il est difficile d'irradier de la même façon chaque microcristal de glace du fait d'un problème de synchronisation avec le laser. Dans le cas du document [3], les variations d'intensité EUV sont dues aux instabilités du jet continu d'azote.

On connaît aussi, par le document [4], une source de rayonnement EUV fondée sur l'irradiation d'un jet gazeux qui entraîne des microparticules par exemple métalliques. Cette technique connue présente une bonne stabilité d'émission de rayonnement EUV, comme la technique utilisant des jets d'agrégats de xénon mais avec une densité de particules beaucoup plus faible. Il en résulte une production de rayonnement EUV nettement plus faible.

De plus, le gaz porteur ne participe pas directement à la génération du rayonnement EUV. Il existe donc, à haute cadence, une charge importante de gaz superflu qu'il faut pomper, d'où des vibrations comme dans le cas des jets d'agrégats de xénon.

On cite également les documents [5] et [6] qui sont relatifs à l'émission de rayons X par des agrégats, par exemple des agrégats de krypton, de xénon ou d'argon.

### EXPOSÉ DE L'INVENTION

La présente invention propose une technique de génération de rayonnement EUV qui a quasiment tous les avantages des techniques connues, mentionnées plus haut, sans présenter les inconvénients de ces techniques connues.

Pour ce faire, l'invention utilise une cible constituée par un brouillard dense de gouttelettes micrométriques et submicrométriques de liquide. Cette cible a un rendement de conversion supérieur ou comparable à celui qui est obtenu avec les techniques connues dans le domaine EUV.

Plus généralement, la présente invention concerne un procédé et un dispositif de génération d'un brouillard dense de gouttelettes d'un liquide, ce procédé et ce dispositif étant en particulier utilisables pour la production de rayonnement EUV et ayant aussi une grande fiabilité ainsi qu'une grande simplicité, ce qui est essentiel pour une utilisation industrielle.

De façon précise, la présente invention a pour objet un procédé de génération d'un brouillard composé de gouttelettes d'un liquide, ce procédé étant caractérisé en ce qu'on pressurise le liquide à une pression de l'ordre de 5x10⁵ Pa à 10⁷ Pa et l'on injecte le liquide ainsi pressurisé dans une buse dont le diamètre est compris entre 20 µm et 1 mm, cette buse débouchant dans une zone où la pression est égale ou inférieure à 10⁻² Pa, et l'on engendre ainsi, dans la zone, à la sortie de la buse, un brouillard dense de gouttelettes du liquide dont les tailles sont de l'ordre de 10 µm à 30 µm, la densité moyenne du brouillard étant égale ou supérieure à 10²⁰ molécules/cm³, ce brouillard dense étant fortement confiné sur l'axe de la buse. La densité moyenne du brouillard est égale ou supérieure à 10²⁰ molécules/cm³.

Selon le mode de mise en oeuvre préféré du procédé objet de l'invention, on chauffe la buse. En effet, la génération du brouillard dense absorbe des calories qu'il faut généralement compenser par un apport de chaleur. Cet apport de calories est moindre dans le cas où le liquide utilisé est cryogénique (gaz liquéfié).

En outre, il est avantageux d'apporter au niveau de la buse une quantité de chaleur supérieure à celle que la génération du brouillard dense a absorbé, pour améliorer la régularité des gouttelettes de liquide.

On peut en outre focaliser un faisceau laser sur le brouillard dense ainsi obtenu, ce faisceau laser étant apte à interagir avec ce brouillard dense pour engendrer une lumière dans le domaine extrême ultraviolet.

De façon avantageuse, on focalise le faisceau laser sur le brouillard dense à une distance de la buse de l'ordre de 1 mm à 10 mm.

Néanmoins on ne sortirait pas du cadre de l'invention en utilisant une distance plus importante pouvant aller jusqu'à plusieurs centimètres.

On peut utiliser la lumière engendrée dans le domaine extrême ultraviolet pour l'insolation d'un substrat sur lequel est déposée une couche de résine photosensible (« photoresist layer »).

La présente invention a également pour objet un dispositif de génération d'un brouillard composé de gouttelettes d'un liquide, ce dispositif étant caractérisé en ce qu'il comprend :
- un réservoir destiné à contenir le liquide,
- des moyens de pressurisation du liquide contenu dans le réservoir, le soumettant à une pression de l'ordre de 5x10⁵ Pa à 10⁷ Pa,
- une buse dont le diamètre est compris entre 20 µm et 1 mm et qui est reliée au réservoir,
- une chambre à vide contenant la buse, et
- des moyens de pompage pour établir dans cette chambre à vide une pression environ égale ou inférieure à 10⁻² Pa,
pour engendrer ainsi, dans la chambre à vide, à la sortie de la buse, un brouillard dense de gouttelettes du liquide dont les tailles sont de l'ordre de 10 µm à 30 µm, la densité moyenne du brouillard étant égale ou supérieure à 10²⁰ molécules/cm³, ce brouillard dense étant fortement confiné sur l'axe de la buse.

Selon un mode de réalisation particulier du dispositif objet de l'invention, ce dispositif comprend en outre des moyens de chauffage de la buse.

Les moyens de pressurisation comprennent par exemple des moyens d'injection d'un gaz sous pression dans le réservoir.

Selon un mode de réalisation particulier de l'invention, la buse est munie de moyens de pulsation pour produire le brouillard dense sous forme pulsée.

Le dispositif objet de l'invention est en particulier utilisable avec de l'eau en tant que liquide.

La présente invention concerne aussi une source de lumière dans le domaine extrême ultraviolet, cette source comprenant :
- le dispositif de génération de brouillard objet de l'invention,
- des moyens de génération d'un faisceau laser apte à interagir avec le brouillard dense engendré grâce au dispositif, et
- des moyens de focalisation du faisceau laser sur ce brouillard dense.

La présente invention concerne en outre un appareil de lithographie de substrats semiconducteurs, cet appareil comprenant :
- des moyens de support d'un substrat semiconducteur sur lequel est déposée une couche de résine photosensible qui est destinée à être insolée suivant un motif déterminé,
- un masque comprenant le motif déterminé sous une forme agrandie,
- une source de lumière dans le domaine extrême ultraviolet,
- des moyens optiques de transmission de la lumière au masque, ce dernier fournissant une image du motif sous forme agrandie, et
- des moyens optiques de réduction de cette image et de projection de l'image réduite sur la couche de résine photosensible,
appareil dans lequel la source est conforme à la source de lumière objet de l'invention.

### BRÈVE DESCRIPTION DES DESSINS

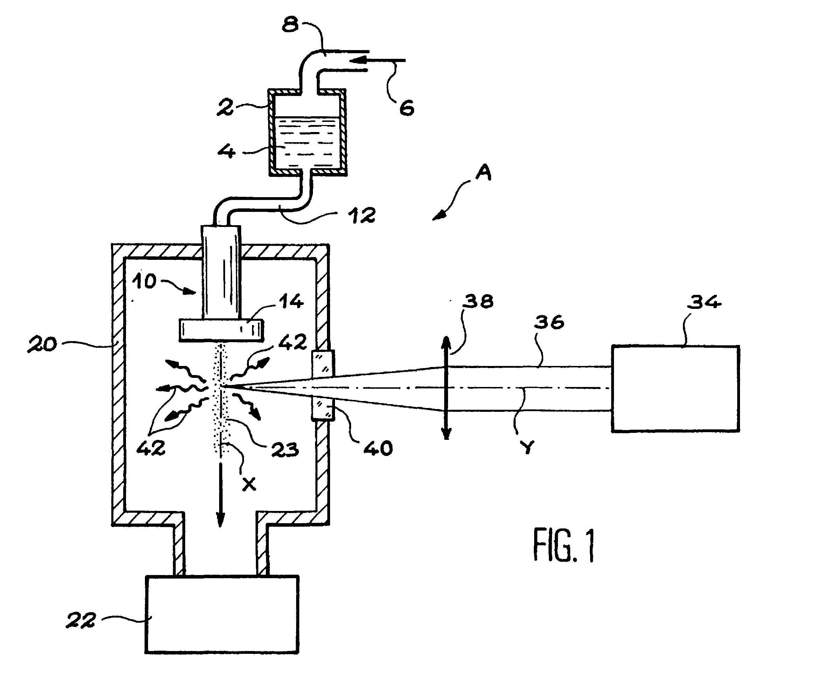

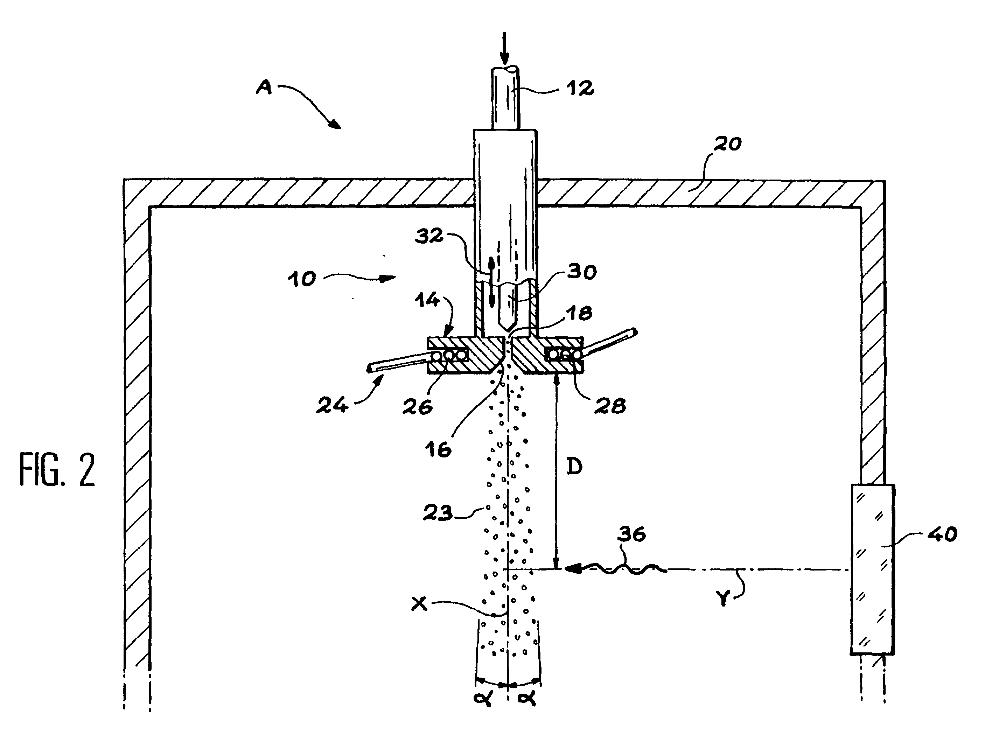

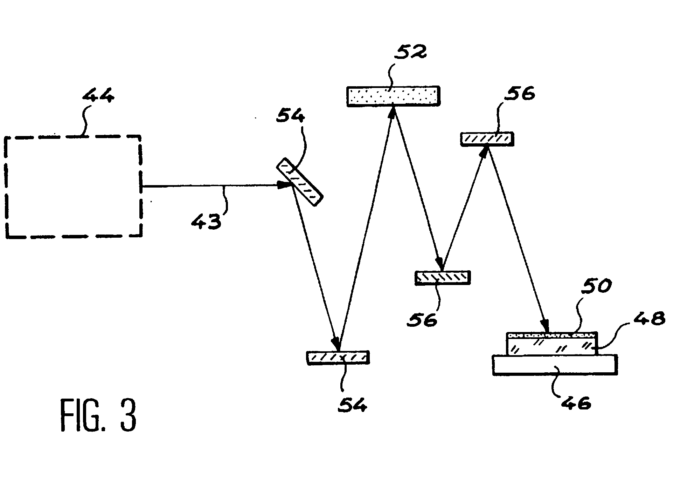

La présente invention sera mieux comprise à la lecture de la description d'exemples de réalisation donnés ci-après, à titre purement indicatif et nullement limitatif, en faisant référence aux dessins annexés sur lesquels :
■ la figure 1 est une vue schématique d'un mode de réalisation particulier du dispositif de génération de brouillard dense de gouttelettes objet de l'invention,
■ la figure 2 est une vue schématique de la buse que comprend le dispositif de la figure 1, et
■ la figure 3 est une vue schématique d'un appareil de lithographie conforme à l'invention.

### EXPOSÉ DÉTAILLÉ DE MODES DE RÉALISATION PARTICULIERS

Le dispositif A de génération de brouillard conforme à l'invention, qui est schématiquement représenté sur la figure 1 et dont une partie est schématiquement représentée sur la figure 2, comprend un réservoir 2 qui est destiné à contenir un liquide 4 avec lequel on veut engendrer un brouillard dense de gouttelettes micrométriques et submicrométriques.

Le dispositif A comprend aussi des moyens de pressurisation du liquide 4 contenu dans le réservoir 2. Ces moyens de pressurisation sont symbolisés par la flèche 6 de la figure 1 et, dans l'exemple représenté, sont des moyens prévus pour envoyer un gaz sous pression dans le réservoir.

Ce gaz sous pression, issu de moyens non représentés, est un gaz inerte comme par exemple l'air, l'azote ou l'argon.

La pression de ce gaz, qui s'exerce sur le liquide, est de 5x10⁵ Pa à 10⁷ Pa.

Le gaz sous pression est envoyé à la partie supérieure du réservoir 2 par l'intermédiaire d'une canalisation 8.

Le dispositif A conforme à l'invention comprend aussi une buse 10 qui communique avec le fond du réservoir 2 par l'intermédiaire d'une canalisation 12. Cette buse 10 est par exemple en métal, en céramique ou en quartz.

Sur les figures 1 et 2, la buse 10 est orientée verticalement mais toute autre orientation, en fonction des besoins, par exemple une orientation horizontale, est possible.

La partie inférieure 14 de la buse 10 comporte un trou 16 dont la forme peut être par exemple cylindrique, conique ou exponentielle.

Le diamètre de l'extrémité supérieure 18 de ce trou 16 est compris entre 20 µm et 1 mm. Ce diamètre constitue ce que l'on appelle le « diamètre de la buse ».

La buse 10 débouche dans une chambre à vide (« vacuum chamber ») 20. Cette chambre à vide 20 est munie de moyens de pompage 22 permettant d'y établir une pression environ égale à 10⁻² Pa.

Le liquide, par exemple de l'eau, qui arrive dans la buse 10, est ainsi violemment expulsé à travers le trou 16 de celle-ci dans la chambre à vide 20 et y forme une brume de forte densité 23, ou brouillard dense, de gouttelettes micrométriques et submicrométriques du liquide.

Les diamètres de ces gouttelettes sont de l'ordre de 10 µm à 30 µm.

La brume 23 est fortement confinée sur l'axe X de la buse qui est aussi l'axe du trou 16 de cette buse.

Dans le dispositif conforme à l'invention des figures 1 et 2, aucun refroidissement de la buse 10 n'est nécessaire pour obtenir le brouillard dense et hautement directif 23.

Cependant, on prévoit de préférence des moyens 24 de chauffage de la buse. Dans l'exemple représenté sur la figure 2, ces moyens de chauffage 24 comprennent un cordon chauffant 26 qui est enroulé dans une rainure circulaire 28 dont l'axe est l'axe X et qui est formée sur la partie inférieure 14 de la buse 10.

Des moyens non représentés sont prévus pour faire circuler un courant électrique dans ce cordon chauffant 26.

Ce chauffage de la buse 10 permet, outre la compensation des calories absorbées par le liquide lors de la formation du brouillard dense, d'améliorer la régularité des gouttelettes de liquide formées. Cette meilleure régularité permet notamment d'améliorer le rendement d'interaction entre un faisceau laser et les gouttelettes, dans l'application particulière du brouillard dense qui sera considérée plus loin et qui est relative à la génération d'un rayonnement EUV au moyen d'une telle interaction.

On utilise par exemple des moyens de chauffage 24 permettant de chauffer la buse 10 à des températures inférieures ou égales à 300°C.

La taille des gouttelettes de liquide contenues dans le brouillard dense 23 dépend de la température de la buse 10 et des paramètres géométriques de cette buse (en particulier de la forme du trou 16 de celle-ci).

Ces paramètres doivent être optimisés en fonction des propriétés du liquide utilisé, comme par exemple la viscosité, la pression de vapeur et le point d'ébullition de ce liquide.

Dans le cas de l'utilisation d'eau, il est préférable d'utiliser un réservoir 2 et une canalisation 12 faits d'aluminium ou d'acier inoxydable ou intérieurement recouverts de Téflon (marque déposée) afin d'éviter la corrosion interne de ce réservoir et de cette canalisation.

On peut former un brouillard dense continu de gouttelettes du liquide ou, au contraire, un brouillard pulsé.

Pour former un tel brouillard pulsé, on prévoit par exemple, à l'intérieur de la buse 10, un piston 30, dont l'extrémité est pointue et destinée à obturer périodiquement le trou 16, ainsi que des moyens symbolisés par la flèche 32 de la figure 2, réalisables par l'homme du métier et prévus pour faire osciller le piston 30 suivant l'axe X de la buse.

Ces moyens d'oscillation 32 sont par exemple électromagnétiques ou piézoélectriques.

La fréquence de pulsation du piston 30 est par exemple de l'ordre de 20 Hz, mais peut être portée à 1 kHz, par des techniques connues de l'homme du métier.

Le brouillard 23 de gouttelettes micrométriques ou submicrométriques ressemble beaucoup à un jet de très gros agrégats mais présente une directivité beaucoup plus prononcée.

Dans le cas de l'eau, le demi-angle de divergence α (figure 2) du brouillard 23 est de l'ordre de 1°.

Dans le cas de l'application de l'invention à la génération d'un rayonnement EUV, il devient alors possible de faire interagir le faisceau laser d'excitation à une grande distance D de la buse 10 et ainsi d'éviter l'érosion de cette buse par le plasma résultant de l'interaction entre le liquide (l'eau) et le faisceau laser.

Cette distance D est représentée sur la figure 2. C'est la distance entre l'extrémité inférieure 14 de la buse 10 et l'axe Y du faisceau laser focalisé sur le brouillard dense 23.

La distance D peut être ajustée entre 2 mm et 10 mm.

En outre, les gouttelettes de liquide, qui sont injectées dans la chambre à vide 20, peuvent passer presque intégralement à travers la zone de focalisation du faisceau laser. On réduit ainsi considérablement la quantité de matière qui n'est pas impliquée dans la génération de rayonnement EUV.

Le fort confinement du brouillard 23 de gouttelettes d'eau permet également l'utilisation de moyens de pompage 22 du genre cryogénique.

On précise que ces moyens de pompage communiquent avec l'intérieur de la chambre à vide 20 par une ouverture disposée en face de l'extrémité inférieure 14 de la buse 10 et traversée par l'axe (géométrique) X.

Des moyens de pompage cryogénique sont bon marché, ont une grande efficacité et n'engendrent pas de vibrations.

La glace formée peut ensuite être évacuée de la chambre à vide 20 au moyen de diverses méthodes, par exemple à l'aide d'un dispositif (non représenté) comprenant un sas, afin d'assurer un fonctionnement sans interruption du dispositif.

On considère maintenant l'application du brouillard dense 23 de gouttelettes de liquide à la génération d'un rayonnement EUV.

Pour exciter ce brouillard 23, on utilise une irradiation par laser du genre de celle qui est décrite dans le document [1].

On utilise par exemple un laser nanoseconde 34 du genre Nd:YAG ou excimère, ayant une durée d'impulsion comprise entre 0,1 nanoseconde et 100 nanosecondes et une énergie par impulsion supérieure à 10 mJ.

Le faisceau 36 fourni par le laser 34 est focalisé, à l'aide d'une lentille 38 ou d'un miroir, sur le brouillard 23 afin d'obtenir, au niveau de ce brouillard, un éclairement laser compris entre 10¹⁰ W/cm² et 10¹⁴ W/cm².

On précise que, dans l'exemple représenté, le faisceau laser 36 est introduit dans la chambre à vide 20 à travers un hublot 40 transparent à ce faisceau laser et monté sur une paroi de la chambre à vide.

Sur la figure 1, l'intense rayonnement EUV émis par les gouttelettes de liquide est symbolisé par les flèches 42 orientées selon toutes les directions. Toutefois la plus grande quantité de lumière EUV est produite par la demi-sphère de plasma faisant face au faisceau laser.

Un ou plusieurs hublots (non représentés) sont prévus sur une ou plusieurs parois de la chambre 20 pour récupérer le rayonnement EUV en vue de son utilisation.

Pour l'application du rayonnement EUV à la nanolithographie, il est préférable que la longueur d'onde du rayonnement EUV émis par le brouillard 23 se situe dans la gamme allant de 10 nanomètres à 14 nanomètres, qui est la gamme optimale de longueurs d'onde des optiques réflectives prévues pour cette nanolithographie.

Pour obtenir de telles longueurs d'onde, on utilise par exemple l'eau en tant que liquide afin d'engendrer la radiation de la transition d'oxygène O⁵⁺ 1s²2p-1s²4d (située à 13 nm).

Il convient de noter que l'eau présente l'avantage d'être peu coûteuse. Contrairement au xénon, elle ne nécessite aucun dispositif de recyclage.

Cependant, il est possible d'utiliser d'autres liquides, des mélanges de liquides ou encore des solutions, afin d'optimiser la génération du rayonnement EUV entre 10 nanomètres et 14 nanomètres ou aux environs d'une autre longueur d'onde si cela s'avère nécessaire.

Le brouillard dense de gouttelettes micrométriques ou submicrométriques de liquide sous vide obtenu conformément à l'invention a les avantages d'un jet d'agrégats de xénon (couplage brouillard-laser conduisant à des taux d'absorption voisins de 1 et absence de débris solides susceptibles de dégrader des optiques de traitement du rayonnement EUV).

Mais le dispositif au moyen duquel on engendre ce brouillard dense est plus simple et plus fiable que celui au moyen duquel les agrégats de xénon sont engendrés.

En principe, la production d'un jet d'agrégats d'eau serait possible conformément au document [1] mais la technique de production de ce jet serait complexe car il faudrait gazéifier l'eau et la maintenir à l'état gazeux jusqu'au moment de l'expansion adiabatique dans le vide à travers une buse.

De plus, pour produire des agrégats de tailles importantes il faudrait, comme dans le cas du xénon, utiliser un refroidissement cryogénique de la buse. La production d'agrégats d'eau de taille suffisante par une telle technique serait extrêmement difficile.

La figure 3 illustre très schématiquement l'utilisation du rayonnement EUV obtenu avec un dispositif conforme à l'invention pour la nanolithographie.

L'appareil de nanolithographie schématiquement représenté sur cette figure 3 comprend un dispositif 44 de génération de rayonnement EUV du genre de la source de rayonnement EUV qui a été décrite en faisant référence à la figure 1.

L'appareil de nanolithographie de la figure 3 comprend aussi un support 46 pour le substrat semiconducteur 48 que l'on veut traiter et qui est recouvert d'une couche 50 de résine photosensible destinée à être insolée suivant un motif déterminé.

L'appareil comprend aussi :
- un masque 52 comprenant ce motif sous une forme agrandie,
- des optiques 54 prévues pour mettre en forme un rayonnement EUV référencé 43, issu du dispositif 44, et amener ce rayonnement 43 au masque 52 qui fournit alors une image du motif sous forme agrandie, et
- des optiques 56 prévues pour réduire cette image agrandie et projeter l'image réduite sur la couche 50 de résine photosensible.

Le support 46, le masque 52 et les optiques 54 et 56 sont disposés dans une chambre à vide non représentée qui, par souci de simplification, est de préférence la chambre à vide dans laquelle on forme le rayonnement EUV d'insolation 43.

Les documents cités dans la présente description sont les suivants :
[1] Kubiak et al., « Cluster beam targets for laser plasma extreme ultraviolet and soft X-ray sources », US 5 577 092 A
[2] Richardson et al., « Water laser plasma X-ray point sources », US 5 577 091 A
[3] Hertz et al., « Method and apparatus for generating X-ray or EUV radiation », demande internationale PCT/SE97/00697 du 25 avril 1997
[4] Matsui et al., « Laser plasma X-ray source, and semiconductor lithography apparatus and method using the same », EP 0858249 A
[5] McPherson et al., « Multiphoton-induced X-ray émission and amplification from clusters », Applied Physics B57,667-347 (1993)
[6] Mc Pherson et al., « Multiphoton-induced X-ray emission from Kr Clusters on M-Shell (∼100Å) and L-shell (∼6Å) transitions », Physical review letters vol.72, n°12 (1994), p.1810 à 1813
[7] Kubiak et al., « Scale-up of a cluster jet laser plasma source for Extreme Ultraviolet Lithography », SPIE vol.3676, SPIE Conference on Emerging Lithographic Technologies III, Mars 1999, p.669 à 678.

## Revendications

1. Procédé de génération d'un brouillard (23) composé de gouttelettes d'un liquide (4), ce procédé étant **caractérisé en ce qu'**on pressurise le liquide (4) à une pression de l'ordre de 5x10⁵ Pa à 10⁷ Pa et l'on injecte le liquide ainsi pressurisé dans une buse (10) dont le diamètre est compris entre 20 µm et 1 mm, cette buse débouchant dans une zone où la pression est égale ou inférieure à 10⁻² Pa, et l'on engendre ainsi, dans la zone, à la sortie de la buse (10), un brouillard dense (23) de gouttelettes du liquide dont les tailles sont de l'ordre de 10 µm à 30 µm, ce brouillard dense étant fortement confiné sur l'axe (X) de la buse.

2. Procédé selon la revendication 1, dans lequel on chauffe la buse (10).

3. Procédé de génération de rayonnement dans le domaine extrême ultraviolet utilisant le procédé de génération d'un brouillard selon l'une quelconque des revendications 1 et 2, dans lequel on focalise en outre un faisceau laser (36) sur le brouillard dense (23) ainsi obtenu, ce faisceau laser étant apte à interagir avec ce brouillard dense pour engendrer une lumière (42) dans le domaine extrême ultraviolet.

4. Procédé selon la revendication 3, dans lequel on focalise le faisceau laser (36) sur le brouillard dense (23), à une distance (D) de la buse (10) de l'ordre de 1 mm à 10 mm.

5. Procédé selon l'une quelconque des revendications 3 et 4, dans lequel on utilise la lumière (42) engendrée dans le domaine extrême ultraviolet pour l'insolation d'un substrat (48) sur lequel est déposée une couche (50) de résine photosensible.

6. Dispositif de génération d'un brouillard (23) composé de gouttelettes d'un liquide (4), ce dispositif (A) étant **caractérisé en ce qu'**il comprend :
- un réservoir (2) destiné à contenir le liquide (4),
- des moyens (6) de pressurisation du liquide contenu dans le réservoir, le soumettant à une pression de l'ordre de 5x10⁵ Pa à 10⁷ Pa,
- une buse (10) dont le diamètre est compris entre 20 µm et 1 mm et qui est reliée au réservoir,
- une chambre à vide (20) contenant la buse, et
- des moyens (22) de pompage pour établir dans cette chambre à vide une pression environ égale ou inférieure à 10⁻² Pa,
pour engendrer ainsi, dans la chambre à vide (20), à la sortie de la buse (10), un brouillard dense (23) de gouttelettes du liquide dont les tailles sont de l'ordre de 10 µm à 30 µm, la densité moyenne du brouillard étant égale ou supérieure à 10²⁰ molécules/cm³, ce brouillard dense étant fortement confiné sur l'axe (X) de la buse.

7. Dispositif selon la revendication 6, comprenant en outre des moyens (24) de chauffage de la buse (10).

8. Dispositif selon l'une quelconque des revendications 6 et 7, dans lequel les moyens de pressurisation comprennent des moyens (6) d'injection d'un gaz sous pression dans le réservoir (2).

9. Dispositif selon l'une quelconque des revendications 6 à 8, dans lequel la buse (10) est munie de moyens (30) de pulsation pour produire le brouillard dense sous forme pulsée.

## Patentansprüche

1. Verfahren zur Erzeugung eines Nebels (23) aus Tröpfchen einer Flüssigkeit (4),
**dadurch gekennzeichnet, dass** man die Flüssigkeit unter einen Druck in der Größenordnung von 5x10⁵ Pa bis 10⁷ Pa setzt und dann die unter Druck gesetzte Flüssigkeit in eine Düse (10) mit einem Durchmesser zwischen 20 µm und 1 mm einspeist, wobei diese Düse in einer Zone mündet, wo der Druck gleich 10⁻² Pa ist oder niedriger, und man derart in der Zone am Ausgang der Düse (10) einen dichten Nebel (23) aus Flüssigkeitströpfchen erzeugt, deren Größen 10 µm bis 30 µm betragen, und die mittlere Dichte des Nebels dabei gleich 10²⁰ Moleküle/cm³ ist oder höher, wobei dieser Nebel stark auf die Achse (X) der Düse beschränkt ist.

2. Verfahren nach Anspruch 1, bei dem man die Düse (10) heizt.

3. Verfahren zur Erzeugung von Strahlung im ultravioletten Grenzbereich mit Anwendung des Nebelerzeugungsverfahrens nach einem der Ansprüche 1 und 2, bei dem man außerdem einen Laserstrahl (36) auf den derart erzeugten dichten Nebel (23) fokussiert, wobei dieser Laserstrahl fähig ist, mit diesem dichten Nebel zusammenzuwirken, um ein Licht (42) im ultravioletten Grenzbereichs zu erzeugen.

4. Verfahren nach Anspruch 3, bei dem man den Laserstrahl (36) mit einem Abstand (D) der Größenordnung 1 mm bis 10 mm von der Düse (10) auf den dichten Nebel fokussiert.

5. Verfahren nach einem der Ansprüche 3 und 4, bei dem man das im ultravioletten Grenzbereich erzeugte Licht dazu benützt, ein Substrat (48) zu bestrahlen, auf dem eine Schicht (50) aus Photoresist abgeschieden ist.

6. Vorrichtung zur Erzeugung eines Nebels (23) aus Tröpfchen einer Flüssigkeit (4), wobei diese Vorrichtung (A) **dadurch gekennzeichnet ist, dass** sie umfasst:
- einen Behälter (2) zur Aufnahme der Flüssigkeit (4),
- Einrichtungen (6) zur Unter-Druck-Setzung der in dem Behälter enthaltenen Flüssigkeit, wobei dieser Druck 5x10⁵ Pa bis 10⁷ Pa beträgt,
- eine Düse (10), deren Durchmesser zwischen 20 µm und 1 mm enthalten ist und die mit dem Behälter verbunden ist,
- eine die Düse enthaltende Vakuumkammer (20), und
- Pumpeinrichtungen (22), um in dieser Vakuumkammer einen Druck zu erzeugen, der ungefähr 10⁻² Pa oder weniger beträgt,
um derart in der Vakuumkammer (20), am Ausgang der Düse (10), einen dichten Nebel (23) aus Flüssigkeitströpfchen zu erzeugen, deren Größen 10 µm bis 30 µm betragen, und die mittlere Dichte des Nebels dabei gleich 10²⁰ Moleküle/cm³ ist oder höher, wobei dieser Nebel stark auf die Achse (X) der Düse beschränkt ist.

7. Vorrichtung nach Anspruch 6, die außerdem Einrichtungen (24) zum Heizen der Düse (10) umfasst.

8. Vorrichtung nach einem der Ansprüche 6 und 7, bei der die Unter-Druck-Setzungseinrichtungen Zuführungseinrichtungen (6) eines Druckgases in den Behälter (2) umfassen.

9. Vorrichtung nach einem der Ansprüche 6 bis 8, bei der die Düse (10) mit Pulsationseinrichtungen (30) ausgerüstet ist, um den dichten Nebel in pulsierender bzw. gepulster Form zu erzeugen.

## Claims

1. Process for generation of a fog (23) composed of droplets of a liquid (4), this process being **characterized in that** the liquid (4) is pressurized at a pressure of the order of 5 x 10⁵ Pa to 10⁷ Pa and the liquid thus pressurized is injected into a nozzle (10) with a diameter of between 20 µm and 1 mm, this nozzle opening up into an area in which the pressure is equal to or less than 10⁻² Pa and thus generates a dense fog (23) of liquid droplets with sizes of the order of 10 µm to 30 µm, the average density of the fog being equal or higher than 10²⁰ molecules/cm³, at the area at the exit from the nozzle (10), this dense fog being closely confined on the centre line (X) of the nozzle.

2. Process according to claim 1, in which the nozzle (10) is heated.

3. Process for generating radiation in the extreme ultraviolet range using the fog generation process according to either of claims 1 and 2, in which a laser beam (36) is also focused on the dense fog (23) thus obtained, this laser beam being capable of interacting with this dense fog to generate light (42) in the extreme ultraviolet range.

4. Process according to claim 3, in which the laser beam (36) is focused on the dense fog (23), at a distance (D) of the order of 1 mm to 10 mm from the nozzle (10).

5. Process according to either of claims 3 or 4, in which light (42) generated in the extreme ultraviolet range is used for insolation of a substrate (48) on which a photoresist layer (50) is deposited.

6. Device for generating a fog (23) composed of droplets of a liquid (4), the device (A) being **characterized in that** it contains:
- a reservoir (2) that will contain the liquid (4),
- means (6) of pressurization of the liquid contained in the reservoir, by subjecting it to a pressure of the order of 5 x 10⁵ Pa to 10⁷ Pa,
- a nozzle (10), the diameter of which is between 20 µm and 1 mm and that is connected to the reservoir,
- a vacuum chamber (20) containing the nozzle, and
- pumping means (22) to set up a pressure less than or equal to about 10⁻² Pa in this vacuum chamber,
to thus generate a dense fog (23) of liquid droplets in the vacuum chamber at the exit from the nozzle (10), with sizes of the order of 10 µm to 30 µm, the average density of the fog being equal to or higher than 10²⁰ molecules/cm³, this dense fog being closely confined on the centre line (X) of the nozzle.

7. Device according to claim 6, also comprising means (24) of heating the nozzle (10).

8. Device according to either of claims 6 and 7, in which the pressurization means include means (6) of injecting a pressurized gas into the reservoir (2).

9. Device according to any one of claims 6 to 8, in which the nozzle (10) is provided with pulsing means (30) to produce the dense fog in pulsed form.
